(19) Europäisches Patentamt
European Patent Office
Office européen des brevets

(11) EP 4 752 162 A1

(12) **EUROPEAN PATENT APPLICATION**
published in accordance with Art. 153(4) EPC

(43) Date of publication:
**03.06.2026 Bulletin 2026/23**

(21) Application number: **24940304.9**

(22) Date of filing: **30.05.2024**

(51) International Patent Classification (IPC):
***C08F 210/16*** (2006.01) ***C08F 210/14*** (2006.01)
***C08F 210/08*** (2006.01) ***C08F 4/64*** (2006.01)
***C08F 4/6592*** (2006.01) ***C09J 123/08*** (2006.01)
***C09J 4/06*** (2006.01)

(86) International application number:
**PCT/CN2024/096374**

(87) International publication number:
**WO 2025/231948 (13.11.2025 Gazette 2025/46)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **09.05.2024 CN 202410566737**

(71) Applicant: **Wanhua Chemical Group Co., Ltd.**
**Yantai, Shandong 264006 (CN)**

(72) Inventors:
- **WANG, Jinqiang**
  **Chongqing Street, YEDA Yantai, Shandong 264006 (CN)**
- **ZHANG, Yanyu**
  **Chongqing Street, YEDA Yantai, Shandong 264006 (CN)**
- **JIAO, Dong**
  **Chongqing Street, YEDA Yantai, Shandong 264006 (CN)**
- **LUO, Kexin**
  **Chongqing Street, YEDA Yantai, Shandong 264006 (CN)**
- **YANG, Ying**
  **Chongqing Street, YEDA Yantai, Shandong 264006 (CN)**
- **LIN, Xiaojie**
  **Chongqing Street, YEDA Yantai, Shandong 264006 (CN)**
- **WANG, Dalin**
  **Chongqing Street, YEDA Yantai, Shandong 264006 (CN)**
- **WANG, Lei**
  **Chongqing Street, YEDA Yantai, Shandong 264006 (CN)**

(74) Representative: **Potter Clarkson**
**Chapel Quarter**
**Mount Street**
**Nottingham NG1 6HQ (GB)**

# (54) ETHYLENE-?-OLEFIN COPOLYMER AND PREPARATION METHOD THEREFOR

(57) The present application relates to the field of olefin polymerization and provides an ethylene-α-olefin copolymer, a preparation method therefor, an encapsulant composition comprising the ethylene-α-olefin copolymer, and a packaging adhesive film formed by the encapsulant composition. The ethylene-α-olefin copolymer has a density of 0.860-0.905 g/cm$^3$; a weight average molecular weight of 20000-150000 g/mol and a molecular weight distribution broadness PDI within the range of 2.2-3, as measured by a GPC-IR test; a singlet elution peak as measured by TGIC, with the product of the full width at half maximum and the half of the peak height being from 38 to 48 and the temperature at a point of intersection between a horizontal line at the half of the peak height and a right-side elution curve being 88-98°C; and a soluble substance content of less than or equal to 3.0%, as measured by TGIC from an elution peak. The copolymer is used for packaging solar cells, solves the problems of a long time for mixing auxiliaries or an insufficient degree of crosslinking during processing, and effectively reduces the generation of crystal points during casting film formation.



Processed by Luminess, 75001 PARIS (FR)

## Description

### TECHNICAL FIELD

The present application relates to the field of olefin polymerization, for example, to an ethylene-α-olefin copolymer exhibiting enhanced crosslinking degree or shortened additive mixing time, and high mechanical strength, a method for preparing the same, an encapsulant composition including the ethylene-α-olefin copolymer, and a solar cell encapsulation film formed using the encapsulant composition.

### BACKGROUND

Polyolefins are the largest-volume products of polymeric materials, characterized by low cost, low density, and ease of processing, and are widely used in many fields such as industrial, agricultural, military, and medical industries. Polyethylene is a particularly important product in the polyolefin industry and currently constitutes the most produced product in general synthetic resins worldwide. Copolymers obtained by copolymerizing ethylene with α-olefins exhibit both the plasticity of plastics and the high elasticity of rubbers, and currently represent one of the primary directions in the development of high-end polyolefin materials.

In the context of global environmental challenges, energy issues are becoming increasingly severe. Solar cells have attracted attention as a non-polluting and inexhaustible energy source. When deployed outdoors such as on building rooftops, solar cells are typically assembled into solar cell modules. Regarding the fabrication of solar cell modules, a crystalline solar cell module can be obtained by sequentially stacking the following components: front glass / solar cell encapsulant / crystalline solar cell device / solar cell encapsulant / back glass (or rear protective sheet). As encapsulants for solar cells, ethylene-vinyl acetate copolymers or ethylene-α-olefin copolymers are commonly used due to their excellent transparency, flexibility, adhesion, and other properties. Ethylene-α-olefin copolymers exhibit superior anti-PID performance and are gradually becoming the mainstream choice and future development direction for photovoltaic cell encapsulation. When ethylene-α-olefin copolymers are used to prepare photovoltaic films, a certain level of mechanical strength is required, making the inherent mechanical properties of the material critically important. Furthermore, to enhance mechanical strength and heat resistance, it is typically required to add co-crosslinking agents. However, polar materials for crosslinking such as crosslinking agents and co-crosslinking agents exhibit poor affinity with ethylene-α-olefin copolymers, which may easily cause failure to achieve the required crosslinking degree or prolonged mixing time for additive incorporation, thereby affecting processing efficiency and limiting the application of ethylene-α-olefin copolymers in the field of photovoltaic encapsulation. Moreover, during photovoltaic film processing, polar additives are first blended into pellets, which are then cast on a casting machine at a temperature below the decomposition temperature of the crosslinking agent. Due to the relatively low processing temperature, crystal spots tend to form readily during film formation from pellets, affecting the service life of the resulting photovoltaic cell after encapsulation. Therefore, there remains a continuous need to develop specialized ethylene-α-olefin copolymers with special properties; particularly, there remains a continuous need to develop ethylene-α-olefin copolymers exhibiting high mechanical strength and good cast-film formability, and avoiding the formation of crystal spots. Since mechanical properties of the encapsulation film are positively correlated with crosslinking degree, i.e. higher crosslinking degree results in better mechanical performance, it is crucial to develop ethylene-α-olefin copolymers that are readily crosslinked.

### SUMMARY OF THE INVENTION

The following provides a summary of the subject matter described in detail herein. The summary is not intended to limit the protection scope of the claims.

In view of the foregoing background, the present application provides an ethylene-α-olefin copolymer and a method for preparing the same. The copolymer exhibits distinctive properties: a density of 0.860 g/cm$^3$ to 0.905 g/cm$^3$; a weight-average molecular weight in a range of 20000 g/mol to 150000 g/mol, as measured by GPC-IR; a unimodal GPC-IR curve and a polydispersity index (PDI) of 2.2 to 3.0; a unimodal elution peak as determined by TGIC, wherein a product of peak width at half height and half of peak height is in a range of 38 to 48, and a temperature at an intersection point between a half-height line and a right side of an elution curve is in a range of 88°C to 98°C; and a content of a soluble substance (components eluting at temperatures lower than 30°C) in the elution peak, as determined by TGIC, of less than 3%. The copolymer meets the requirements for photovoltaic encapsulation film applications, offering high mechanical strength while simultaneously addressing the issues of prolonged additive mixing time or insufficient crosslinking degree during processing. Moreover, the copolymer demonstrates excellent cast-film formability, effectively reducing the formation of crystal spots, and exhibits strong potential for industrialization.

Therefore, according to a first aspect of the present application, there is provided an ethylene-α-olefin copolymer having the following properties:

(a) a density of 0.860 g/$cm^3$ to 0.905 g/$cm^3$, for example, 0.860 g/$cm^3$, 0.865 g/$cm^3$, 0.870 g/$cm^3$, 0.875 g/$cm^3$, 0.880 g/$cm^3$, 0.885 g/$cm^3$, 0.890 g/$cm^3$, 0.895 g/$cm^3$, 0.900 g/$cm^3$, or 0.905 g/$cm^3$;

(b) a weight-average molecular weight in a range of 20000 g/mol to 150000 g/mol, for example, 20000 g/mol, 30000 g/mol, 40000 g/mol, 50000 g/mol, 60000 g/mol, 70000 g/mol, 80000 g/mol, 90000 g/mol, 100000 g/mol, 110000 g/mol, 120000 g/mol, 130000 g/mol, 140000 g/mol, or 150000 g/mol; and a polydispersity index PDI in a range of 2.2 to 3.0, as measured by GPC-IR;

(c) a unimodal elution peak as determined by TGIC, wherein a product of peak width at half height and half of peak height is in a range of 38 to 48, such as 38, 39, 40, 41, 42, 43, 44, 45, 46, 47, or 48, and a temperature at an intersection point between a half-height line and a right side of an elution curve is in a range of 88°C to 98°C, such as 88°C, 89°C, 90°C, 91°C, 92°C, 93°C, 94°C, 95°C, 96°C, 97°C, or 98°C; and

(d) a content of a soluble substance (components eluting at temperatures lower than 30°C) in the elution peak, as determined by TGIC, of less than or equal to 3.0%, for example, 0.2%, 0.4%, 0.6%, 0.8%, 1.0%, 1.2%, 1.4%, 1.6%, 1.8%, 2.0%, 2.2%, 2.4%, 2.6%, 2.8% or 3.0%.

In one embodiment, the ethylene-α-olefin copolymer described in the present application has a comonomer incorporation rate of 20 wt% to 40 wt%, for example, 20 wt%, 22 wt%, 24 wt%, 26 wt%, 28 wt%, 30 wt%, 32 wt%, 34 wt%, 36 wt%, 38 wt%, or 40 wt%.

In one embodiment, the ethylene-α-olefin copolymer described in the present application has a melt flow rate $MFR_2$ (as measured at 190°C under a load of 2.16 kg) in a range of 1 g/10min to 30 g/10min, for example, 1 g/10min, 2 g/10min, 3 g/10min, 4 g/10min, 5 g/10min, 6 g/10min, 7 g/10min, 8 g/10min, 9 g/10min,10 g/10min, 11 g/10min, 12 g/10min, 13 g/10min, 14 g/10min, 15 g/10min, 16 g/10min, 17 g/10min, 18 g/10min, 19 g/10min, 20 g/10min, 21 g/10min, 22 g/10min, 23 g/10min, 24 g/10min, 25 g/10min, 26 g/10min, 27 g/10min, 28 g/10min, 29g/10min or 30 g/10min.

In one embodiment, the ethylene-α-olefin copolymer described in the present application has a melting peak temperature Tm of 30°C to 90°C.

In one embodiment, the α-olefin in the ethylene-α-olefin copolymer is a $C_3$-$C_{20}$ olefin or a mixture thereof, more preferably one or more selected from the group consisting of propylene, 1-butene, 1-pentene, 4-methyl-1-pentene, 1-hexene, 1-heptene, 1-octene, 1-decene, 1-undecene, 1-dodecene, 1-tetradecene, 1-hexadecene, and 1-eicosene.

According to a second aspect of the present application, there is provided a method for preparing the ethylene-α-olefin copolymer described in the present application, including the steps of:

1) carrying out continuous solution polymerization of ethylene with one or more α-olefins in a reactor in the presence of a catalyst and optionally a chain transfer agent; and

2) quenching at the reactor outlet with a water-alcohol mixture to obtain the ethylene-α-olefin copolymer;

wherein polymerization reaction conditions satisfy the following formula:

$$0.70 < \frac{F_{ethylene} / F_{catalyst}}{C_{catalyst\ efficiency}} < 0.94$$

wherein $F_{ethylene}$ is a feed rate of the ethylene, with a unit of kg/h;
$F_{catalyst}$ is a feed rate of the catalyst, with a unit of g/h; and
$C_{catalyst\ efficiency}$ is a mass of the polymer produced per unit mass of the catalyst per hour, with a unit of kg/g.

In one embodiment, the water-alcohol mixture is a mixture of water and a $C_2$-$C_{10}$ alcohol, with a weight ratio of the water to the $C_2$-$C_{10}$ alcohol of 0.1 to 10.

In one embodiment, the $C_2$-$C_{10}$ alcohol is one or more selected from the group consisting of ethanol, propanol, butanol, 2-methylpropanol, pentanol, 2-methylbutanol, 3-methylbutanol, 2-ethylpropanol, hexanol, 2-methylpentanol, 3-methylpentanol, 4-methylbutanol, 3-ethylbutanol, heptanol, 2-methylhexanol, 3-methylhexanol, 4-methylhexanol, 5-methylhexanol, 3-ethylpentanol, 4-ethylpentanol, octanol, isooctanol, nonanol, isononanol, and decanol.

In one embodiment, the chain transfer agent is hydrogen.

The reactor used is known in the art and may be, for example, a non-stirred or stirred cylindrical or tank-type vessel, a loop reactor, or a combination thereof.

The catalyst used is a homogeneous catalyst conventionally used for the preparation of the copolymer of ethylene and α-olefins, preferably a metallocene catalyst or a post-metallocene catalyst, more preferably, methylsilyl(N-tert-butylamino)(tetramethylcyclopentadienyl)titanium dichloride, dimethylsilyl(N-tert-butylamino)(tetramethylcyclopentadienyl)dimethyltitanium, dimethylsilyl(N-tert-butylamino)(fluorenyl)titanium dichloride, pentamethylcyclopentadienyltitanium trimethoxide, diphenylmethylene(cyclopentadienyl)(9-fluorenyl)zirconium dichloride, dimethylsilyl-bis(2-methyl-4-phenyl-1-indenyl)zirconium dichloride, meso-dimethylsilyl-bis(1-indenyl)zirconium dichloride, bis(methylcyclopentadienyl)zirconium dichloride, bis(1,3-dimethylcyclopentadienyl)zirconium dichloride, trichloro(cyclopentadienyl)(1,2-dimethoxyethane)zirconium, diphenylsilyl(cyclopentadienyl)(9-fluorenyl)zirconium dichloride, rac-dimethylsilyl-bis(2-methyl-1-indenyl)zirconium dichloride, diphenylmethylenecyclopentadienyl(2,7-di-tert-butylfluorenyl)zirconium dichloride, di(p-tolyl)methylene(cyclopentadienyl)(2,7-di-tert-butylfluorenyl)zirconium dichloride, dimethyl-bis(propylcyclopentadienyl)hafnium, bis(n-butyl cyclopentadienyl)hafnium dichloride, dimethylsilyl-bis(2-methyl-4-phenylindenyl)zirconium dichloride, or a compound represented by the following formula:

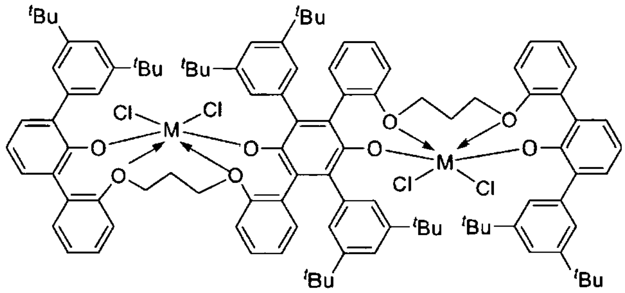

M=Ti, Zr, Hf

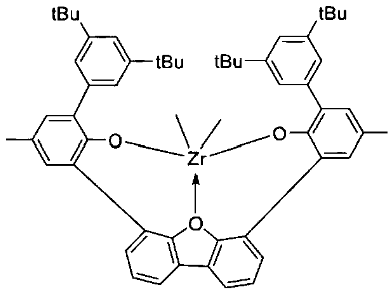

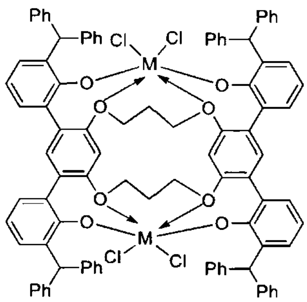

M=Ti, Zr, Hf

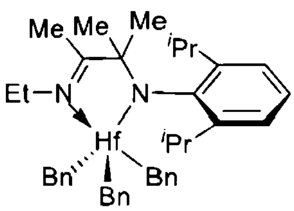

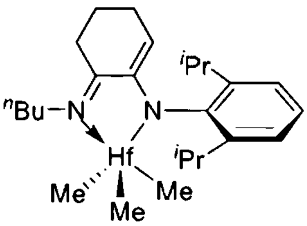

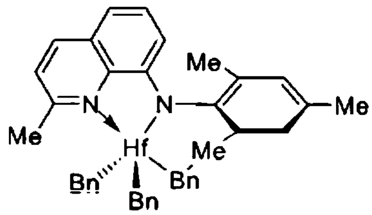 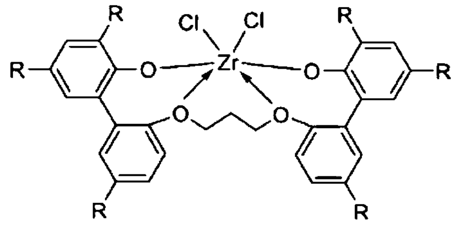

R is $C_1$-$C_{30}$ alkyl, aryl, etc.

A solvent is further present during the solution polymerization. In one embodiment, the solvent is in a liquid or supercritical state under polymerization conditions. The solvent is typically and preferably a hydrocarbon solvent. In one embodiment, the hydrocarbon solvent used is a $C_5$-$C_{12}$ hydrocarbon, which may be unsubstituted or substituted with $C_1$-$C_4$ alkyl groups, such as pentane, methylpentane, hexane, heptane, octane, cyclohexane, methylcyclohexane, or hydrogenated naphtha. More preferably, the hydrocarbon solvent is hexane, $C_6$ mixed alkanes, methylcyclohexane, or IsoparE.

In one embodiment, during the polymerization of the present application, a co-catalyst conventionally used in the art is further added in the polymerization reaction. For example, the co-catalyst is a composition comprising one or more selected from the group consisting of aluminoxanes, alkylaluminum compounds, and alkylaluminum chlorides, or a composition including one or more selected from the group consisting of aluminoxanes, alkylaluminum compounds, and alkylaluminum chlorides in combination with one or more organoboron compounds.

In one embodiment, the aluminoxanes are selected from the group consisting of methylaluminoxane (MAO) and modified methylaluminoxane (MMAO); the alkylaluminum compounds are selected from the group consisting of triethylaluminum, triisobutylaluminum, and trioctylaluminum; the alkylaluminum chlorides are selected from the group consisting of diethylaluminum chloride, sesquiethylaluminum chloride, and aluminium ethyl dichloride; the organoboron compounds are selected from the group consisting of trityl tetrakis(pentafluorophenyl)borate, tris(pentafluorophenyl)borane, N,N-dimethylanilinium tetrakis(pentafluorophenyl)borate, dioctadecylmethylammonium tetrakis(pentafluorophenyl)borate, and di(hydrogenated tallow) methylammonium tetrakis(pentafluorophenyl)borate.

In one embodiment, the molar ratio Al/M of the aluminum metal in the co-catalyst to the transition metal M in the main catalyst is in a range of 5 to 1000, for example, 5, 10, 20, 50, 80, 100, 120, 140, 160, 180, 200, 300, 400, 500, 600, 700, 800, or 1000, more preferably from 10 to 100.

In one embodiment, the molar ratio B/M of boron in the organoboron compound to the transition metal M in the main catalyst is in a range of 0 to 10, for example, 0, 1, 1.5, 2, 2.5, 3, 3.5, 4, 4.5, 5, 6, 7, 8, 9, or 10, preferably 1 to 3.

In one embodiment, the solution polymerization is carried out at a temperature of 120-200°C under a pressure of 2-10 MPa, more preferably at a temperature of 130-190°C and under a pressure of 2-9 MPa.

According to a third aspect of the present application, there is provided an encapsulant composition including the ethylene-α-olefin copolymer described above, or the ethylene-α-olefin copolymer prepared by the method described above. The encapsulant composition can be used to prepare modified resin compositions, such as silane-modified resin compositions or amino silane-modified resin compositions.

In one embodiment, the encapsulant composition is used for solar cell encapsulation. Specifically, the ethylene-α-olefin copolymer simultaneously satisfies the following conditions (a) to (d):

(a) a density of 0.860 g/cm$^3$ to 0.905 g/cm$^3$;

(b) a weight-average molecular weight in a range of 20000 g/mol to 150000 g/mol, and a polydispersity index PDI in a range of 2.2 to 3, as measured by GPC-IR;

(c) a unimodal elution peak as determined by TGIC, wherein a product of peak width at half height and half of peak height is in a range of 38 to 48, and a temperature at an intersection point between a half-height line and a right side of an elution curve is in a range of 88°C to 98°C; and

(d) a content of a soluble substance (components eluting at temperatures lower than 30°C) in the elution peak, as determined by TGIC, of less than 3%.

The specific details of the ethylene-α-olefin copolymer in the aforementioned composition may refer to the corresponding description of the ethylene-α-olefin copolymer described above in the present application, and thus are not repeated herein.

By using the ethylene-α-olefin copolymer of the present application, the above composition achieves enhanced crosslinking degree or shortened mixing time for additives and the copolymer.

The encapsulant composition may further include other components conventionally added in the art, specifically, for example, one or more selected from the group consisting of crosslinking agents, co-crosslinking agents, coupling agents, and antioxidants. Of course, it may also include other additional components permitted in the art.

In one embodiment, the crosslinking agent may be a peroxide-based crosslinking agent, including but not limited to one or more of the following compounds, either individually or in combination: tert-butylperoxy isopropyl carbonate, 2,5-dimethyl-2,5-(di-tert-butylperoxy)hexane, tert-butyl peroxy carbonate 2-ethylhexyl ester, 1,1-bis(tert-butylperoxy)-3,3,5-trimethylcyclohexane, 1,1-bis(tert-amylperoxy)-3,3,5-trimethylcyclohexane, 1,1-bis(tert-amylperoxy)-3,3,5-trimethylcyclohexane, 1,1-bis(tert-amylperoxy)cyclohexane, 1,1-bis(tert-butylperoxy)cyclohexane, 2,2-bis(tert-butylperoxy)butane, tert-butyl peroxy-2-ethylhexyl carbonate, tert-amylperoxy-2-ethylhexyl carbonate, tert-amyl peroxy carbonate, or tert-butyl peroxy-3,3,5-trimethylhexanoate.

The amount of the crosslinking agent may be conventionally determined by those skilled in the art according to requirements. In one embodiment, based on 100 parts by weight of the ethylene-α-olefin copolymer, the crosslinking agent may be used in an amount of 0.1-5 parts by weight, preferably 0.5-2 parts by weight.

In one embodiment, the co-crosslinking agent may be one or more multifunctional acrylates, including but not limited to one or more of the following compounds, either individually or in combination: triallyl isocyanurate, trimethylolpropane triacrylate, trimethylolpropane trimethacrylate, pentaerythritol triacrylate, tris(2-hydroxyethyl) isocyanurate triacrylate, ethoxylated trimethylolpropane triacrylate, propoxylated trimethylolpropane triacrylate, ethoxylated glycerol triacrylate, propoxylated glycerol triacrylate, pentaerythritol tetraacrylate, ethoxylated pentaerythritol tetraacrylate, trimethylolpropane tetraacrylate, di(trimethylolpropane) tetraacrylate, di(trimethylolpropane) tetramethacrylate, propoxylated pentaerythritol tetraacrylate, tricyclodecanedimethanol diacrylate, propoxylated neopentyl glycol diacrylate, ethoxylated bisphenol A diacrylate, ethoxylated bisphenol A dimethacrylate, 2-butyl-2-ethyl-1,3-propanediol diacrylate, diethylene glycol dimethacrylate, triethylene glycol dimethacrylate, or polyethylene glycol dimethacrylate.

In one embodiment, based on 100 parts by weight of the ethylene-α-olefin copolymer, the co-crosslinking agent may be used in an amount of 0.1-5 parts by weight, preferably 0.1-2 parts by weight.

In one embodiment, the coupling agent may be a silane-type coupling agent, including but not limited to one or more of the following compounds, either individually or in combination: γ-methacryloxypropyltrimethoxysilane, γ-chloropropylmethoxysilane, vinylethoxysilane, γ-(2,3-epoxypropoxy)propyl trimethoxysilane, vinyl tris(β-methoxyethoxy)silane, γ-methacryloxypropyltrimethoxysilane, vinyltriacetoxysilane, γ-glycidoxypropyl trimethoxysilane, 3-(trimethoxysilyl) propyl-2-methyl-2-acrylate, anilinomethyltriethoxysilane, or octyltrimethoxysilane.

In one embodiment, based on 100 parts by weight of the ethylene-α-olefin copolymer, the coupling agent may be used in an amount of 0.1-3 parts by weight, preferably 0.1-0.6 parts by weight.

In one embodiment, the antioxidant may be one or more of hindered phenolic antioxidants, phosphate ester antioxidants, or a combination thereof, including but not limited to one or more of the following compounds, either individually or in combination: n-octadecyl-β-(3,5-di-tert-butyl-4-hydroxyphenyl)-propionate, pentaerythritol tetrakis [β-(3,5-di-tert-butyl-4-hydroxyphenyl)propionate], bis(3,5-di-tert-butyl-4-hydroxypropionyl)hydrazide, 2,2'-oxamido-bis [ethyl-3-(3,5-di-tert-butyl-4-hydroxyphenyl)propionate], N,N'-hexamethylene-bis(3,5-di-tert-butyl-4-hydroxyphenyl propionamide), 1,3,5-tris(3,5-di-tert-butyl-4-hydroxybenzyl)-1,3,5-triazinane-2,4,6(1H,3H,5H)-trione, triethylene glycol bis [3-(3-tert-butyl-5-methyl-4-hydroxyphenyl)propionate], 4,6-bis(octylthiomethyl)-o-cresol, tris(2,4-di-tert-butylphenyl) phosphite, bis(2,4-di-tert-butylphenyl) pentaerythritol diphosphite, bis(2,6-di-tert-butyl-4-methylphenyl) pentaerythritol diphosphate.

In one embodiment, based on 100 parts by weight of the ethylene-α-olefin copolymer, the antioxidant may be used in an amount of 0.01-1 part by weight, preferably 0.05-0.5 parts by weight.

In some embodiments, the encapsulant composition includes: 100 parts by weight of the ethylene-α-olefin copolymer; 0.1-5 parts by weight, preferably 0.5-2 parts by weight of the crosslinking agent; 0.1-5 parts by weight, preferably 0.1-2 parts by weight of the co-crosslinking agent; 0.1-3 parts by weight, preferably 0.1-0.6 parts by weight of the coupling agent; and 0.01-1 part by weight, preferably 0.05-0.5 parts by weight of the antioxidant.

According to a fourth aspect of the present application, there is further provided an encapsulation film prepared from the above-described encapsulant composition.

In one embodiment, the encapsulation film is a solar cell encapsulation film.

According to a fifth aspect of the present application, there is provided a method for preparing the encapsulation film, comprising the steps of:

mixing and melting the components of the composition; extruding and casting into a film; and then cooling and slitting.

Specifically, the method may further include a winding step. Specific process operations and conditions of the method can refer to those of conventional methods known in the art, and are not particularly limited.

The present application will be described in more detail with reference to the examples below. The examples are provided for illustrative purposes only and should not be constructed as limiting the scope of the present application.

After reading and understanding the detailed description, other aspects will become apparent.

## DETAILED DESCRIPTION

To facilitate better understanding of the present application by those skilled in the art, the present application will

be further described below with specific examples. The examples are provided solely for illustrative purposes and are not intended to limit the scope of the present application.

Unless otherwise specified, the experimental methods employed in the following examples are conventional methods.

All materials and reagents used in the following examples are commercially available, with details as follows:

IsoparE, 100% hydrogenated naphtha, Mobil;
Mixed $C_6$ alkanes (i.e., $C_6$ mixed alkanes), 100% alkanes, Jingbo Petrochemical;
1-octene, 98%, INEOS;
1-hexene, 99%, Lingyan Biotech;
Ethylene, polymer-grade, Air Liquide;
1-butene, 99%, Mingju;
MMAO, a 7% aluminum solution, Nouryon;
7447, ethylene/butene copolymer, Dow Chemical;
DF740, ethylene/butene copolymer, Mitsui Chemicals;
8658, ethylene/octene copolymer, Dow Chemical;
Dimethylsilyl(N-tert-butylamino)(indenyl)dimethyltitanium, 99%, Sinocompound, designated as M1;
Dimethylsilyl(N-tert-butylamino)(fluorenyl)titanium dichloride, 99%, Strem, designated as M2;
Triisobutylaluminum in hexane, 1 mol/L, Inno-Chem;
Trityl tetrakis(pentafluorophenyl)borate, 99%, Innochem, dissolved in toluene for use, designated as B1;
Diphenylmethylenecyclopentadienyl(2,7-di-tert-butylfluorenyl)zirconium dichloride, Sinocompound, 98%, designated as M3;

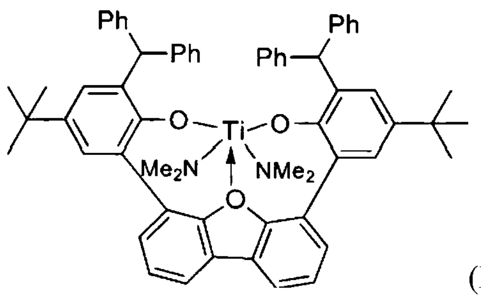

(M4)

Compound (M4) was synthesized according to Example 15 of Chinese Patent publication No. CN 114315883 A.

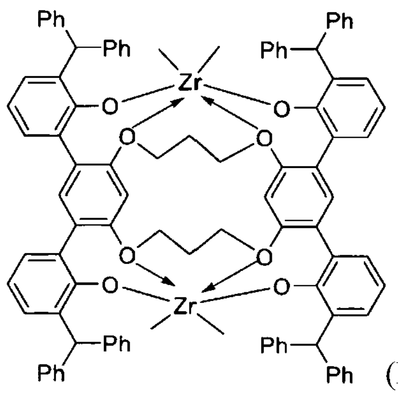

(M5)

Compound (M5) was synthesized according to Example 4 of Chinese Patent Application No. CN 202010793023.8.

tert-Butyl peroxy 2-ethylhexyl carbonate, AkzoNobel, purity >95%;
Triallyl isocyanurate, Acros, purity of 98%;
γ-Methacryloxypropyltrimethoxysilane, Aladdin, purity of 95%;
γ-(2,3-Epoxypropoxy)propyl trimethoxysilane, Aladdin, purity of 95%;
Bis(2,4-di-tert-butylphenyl)pentaerythritol diphosphite, Acros, purity of 95%;
n-Octadecyl-p-(3,5-di-tert-butyl-4-hydroxyphenyl)-propionate, ark, purity of 95%;

1,1-Bis(tert-butylperoxy)-3,3,5-trimethylcyclohexane, Acros, purity of 95%;
tert-Amyl peroxy carbonate, ark, purity of 95%;
Trimethylolpropane triacrylate, Aladdin, purity of 98%;
Antioxidant 1076 (n-octadecyl-β-(3,5-di-tert-butyl-4-hydroxyphenyl)-propionate), Rianlon New Materials Co., Ltd., industrial grade;
Antioxidant 1010 (pentaerythritol tetrakis[β-(3,5-di-tert-butyl-4-hydroxyphenyl) propionate]), Rianlon New Materials Co., Ltd., industrial grade.

The melting peak temperature $T_m$ and melting enthalpy of the polymers obtained in the following examples and comparative examples were determined by differential scanning calorimetry (DSC), using data obtained from the second heating. The heating and cooling rate was 10 °C/min. The specific testing procedure involved cutting the sample pellets and performing DSC analysis on a METTLER DSC 3 differential scanning calorimeter equipped with an FRS6+ sensor. The thermal program was as follows: starting at an initial temperature of 25 °C, the sample was heated to 160 °C at 10 °C/min, cooled to -100 °C at 10 °C/min and held for 3 minutes, and then reheated to 160 °C at 10 °C/min. Nitrogen gas flow rate was 50 mL/min, and sample weight was 5-10 mg. Indium (In) and zinc (Zn) standard materials were used for calibration.

The sample was analyzed for TGIC elution temperature using a Polymer Char TGIC instrument. The sample was dissolved in trichlorobenzene at 165 °C and injected into a TGIC chromatographic column, followed by programmed cooling to 40 °C at a rate of 20 °C/min. Some polyolefin structures were adhered onto the chromatographic column due to adsorption and crystallization on the graphite column. A rinse was performed at a flow rate of 0.5 mL/min, during which the soluble substance was eluted to an IR5 detector for detection. A temperature-rising elution was performed, during which the column was heated to 165 °C at a rate of 2 °C/min, and the molecules adsorbed onto the column were sequentially eluted according to differences in their crystallizability and short branched chain content.

The density of the polymers in the examples and comparative examples was measured using a density meter. The sample pieces were cut from compression-molded sheets and tested using a Mettler XS204 density meter via an immersion method, with anhydrous ethanol (AR grade) as the immersion liquid. The ambient temperature during testing was maintained at 23 °C ± 2 °C, and the test temperature was obtained through internal calibration. The mass of the sample was greater than 1 g, with no air bubbles present. The mass of the sample in air and in the immersion liquid was measured separately, and the sample density was calculated based on Archimedes' principle.

The molecular weight, molecular weight distribution, and comonomer incorporation rate of the polymers in the examples and comparative examples were analyzed using a Polymer Char GPC-IR instrument. The instrument is configured with three internal MIXED chromatographic columns (dimensions: 300 × 7.5 mm) in series and is equipped with three types of detectors: namely, infrared, viscosity, and laser detectors. The IRS MCT infrared detector, specifically designed for polyolefins, was commonly used for detection. Samples were automatically injected into the high-temperature zone (160 °C) of the instrument's autosampler using 8 mL of trichlorobenzene solvent. After one hour of dissolution under agitation, 200 μL of the solution was withdrawn for analysis. The infrared detector temperature was set to 150 °C. Polystyrene (PS) standards were used for molecular weight calibration, and a monomer calibration curve was established using a series of polyolefin elastomers (POE) with varying monomer levels.

All examples were carried out in a 25 L continuous stirred-tank reactor. The solvent, comonomer (selected from octene, hexene, and butene), and ethylene in the system were passed through a fixed-bed column for deoxygenation and dehydration, and then continuously fed into the reactor at the feed rates specified in Table 1. The catalyst and cocatalyst were prepared as solutions and then delivered into the reactor. The reaction temperature was controlled using a pre-reactor heat exchanger and a reactor jacket to maintain the specified setpoint. The pressure was regulated by a pneumatic proportional control valve at the discharge outlet of the reactor and maintained via hydraulic pressure. The reactor effluent was quenched with a water-alcohol mixture at the reactor outlet, with a molar ratio of 8:1 of the water-alcohol mixture to the metal Al of the co-catalyst. Subsequently, the sample was devolatilized, pelletized, and sampled for analysis.

**Examples 1-5 and Comparative Examples 1-3**

The polymerization reaction of ethylene and α-olefin was carried out in a 25 L continuous stirred-tank reactor. The solvent, α-olefin comonomer (octene, hexene, or butene), and ethylene in the system were passed through a fixed-bed column for deoxygenation and dehydration, and then continuously fed into the reactor at the feed rates specified in Table 1. The catalyst and cocatalyst were prepared as solutions and then delivered into the reactor. The reaction temperature was controlled using a pre-reactor heat exchanger and a reactor jacket to maintain the specified setpoint. The pressure was regulated by a pneumatic proportional control valve at the discharge outlet of the reactor and maintained via hydraulic pressure. The reactor effluent was quenched with a water-alcohol mixture at the reactor outlet, with a molar ratio of 8:1 of the water-alcohol mixture to the metal Al of the co-catalyst. Subsequently, the sample was devolatilized, pelletized, and sampled for analysis.

Table 1: Reaction conditions for Examples 1 to 5 and Comparative Examples 1 to 3

| | Solvent | $F_{solvent}$ kg/h | $F_{ethylene}$ kg/h | α-olefin | $F_{\alpha\text{-olefin}}$ kg/h | Catalyst | $C_{catalyst\ efficiency}$ kg/g | $F_{catalyst}$ g/h | $F_{ethylene}$ / $F_{catalys}$ $C_{catalyst\ efficiency}$ | Co-catalyst | A1/M Molar Ratio | Organoboron compounds | B/M Molar Ratio | Temperature °C | Pressure MPa | Alcohol | Water/ Alcohol Mass Ratio |
|---|---|---|---|---|---|---|---|---|---|---|---|---|---|---|---|---|---|
| Example 1 | IsoparE | 95.65 | 18.4 | 1-Octene | 33 | M1 | 115 | 0.217 | 0.736 | MMAO | 200 | - | - | 155 | 5 | Isooctanol | 1 |
| Example 2 | $C_6$ blend | 131.23 | 20.69 | 1-Butene | 33.8 | M2 | 132 | 0.19 | 0.83 | MMAO | 500 | - | - | 165 | 10 | Ethanol | 5 |
| Example 3 | Hexane | 120.47 | 17.91 | 1-Hexene | 41.62 | M3 | 137 | 0.18 | 0.72 | MMAO | 900 | - | - | 135 | 7 | Heptanol | 0.2 |
| Example 4 | $C_6$ blend | 87.53 | 23.31 | 1-Butene | 26 | M4 | 124 | 0.20 | 0.93 | MMAO | 50 | - | - | 188 | 3 | Butanol | 0.5 |
| Example 5 | IsoparE | 89.84 | 19.08 | 1-Octene | 41.09 | M5 | 138 | 0.18 | 0.76 | TIBA | - | B1 | 1 | 170 | 9 | Isooctanol | 8 |
| Comparative Example 1 | Hexane | 120.68 | 17.25 | 1-Hexene | 42.08 | M3 | 135 | 0.19 | 0.69 | MMAO | 900 | - | - | 135 | 7 | Heptanol | 0.2 |
| Comparative Example 2 | $C_6$ blend | 87.25 | 23.95 | 1-Butene | 25.64 | M4 | 123 | 0.20 | 0.96 | MMAO | 50 | - | - | 188 | 3 | Butanol | 0.5 |
| Comparative Example 3 | Ethylene/1-octene copolymer prepared according to CN114867759A POEC | | | | | | | | | | | | | | | | |

Table 2: Properties of ethylene-α-olefin copolymers of Examples 1-5 and Comparative Examples 1-6

| | Density g/cm³ | Mw g/mol | PDI | Melting peak temperature Tm °C | Half of peak height of the TGIC elution peak | Peak width at half height of the TGIC elution peak°C | Product of peak width at half height and half of peak height | Temperature at the intersection point for the right side °C | Content of soluble substance wt% | Comonomer incorporation rate wt% | $MFR_2$ g/10min (190°C, 2.16kg) |
|---|---|---|---|---|---|---|---|---|---|---|---|
| Example 1 | 0.873 | 69500 | 2.2 | 65 | 2.55 | 17 | 43.35 | 93 | 2.1 | 33 | 4.7 |
| Example 2 | 0.877 | 52000 | 2.4 | 63 | 2.3 | 17.5 | 40.25 | 92.5 | 1.6 | 26 | 12.9 |
| Example 3 | 0.863 | 69200 | 2.6 | 35 | 2.9 | 13.5 | 39.15 | 89 | 2.8 | 37 | 5.2 |
| Example 4 | 0.895 | 45000 | 2.8 | 85 | 3.4 | 14 | 47.6 | 97.5 | 0.5 | 22 | 29.5 |
| Example 5 | 0.868 | 112000 | 2.6 | 55 | 2.25 | 19 | 42.75 | 93 | 1.2 | 35 | 1.2 |
| Comparative Example 1 | 0.862 | 71300 | 2.6 | 44 | 2.9 | 12.4 | 35.96 | 89 | 3.1 | 37.4 | 5.2 |
| Comparative Example 2 | 0.896 | 45600 | 2.8 | 85 | 3.5 | 14 | 49 | 97.6 | 0.5 | 21.7 | 29.4 |
| Comparative Example 3 | 0.869 | 47000 | 2.7 | 62 | Bimodal TGIC elution peak | | | | | 36.1 | 29.9 |
| Comparative Example 4 Ethylene/1-butene copolymer DF740 | 0.873 | 74000 | 2.3 | 51 | 3.05 | 14 | 42.7 | 85 | 1.5 | 22.6 | 3.5 |
| Comparative Example 5 Ethylene/1-butene copolymer 7447 | 0.865 | 65000 | 2.6 | 35 | 1.925 | 24 | 46.2 | 90 | 8 | 33 | 5 |
| Comparative Example 6 Ethylene/1-octene copolymer 8658 | 0.902 | 43000 | 2.5 | 96 | 3.4 | 14 | 47.6 | 100 | 1.7 | 25 | 30 |

**Example 6**

9 g of tert-butyl peroxy 2-ethylhexyl carbonate, 4.7 g of triallyl isocyanurate, 1.8 g of γ-methacryloxypropyl trimethoxysilane, 1 g of γ-(2,3-epoxypropoxy)propyl trimethoxysilane, 1 g of bis(2,4-ditert-butylphenyl)pentaerythritol diphosphite, and 1 g of n-octadecyl-β-(3,5-di-tert-butyl-4-hydroxyphenyl)-propionate were added to 1000 g of the ethylene-α-olefin copolymer obtained in example 1.

The above raw materials were heated to 50 °C and uniformly mixed for 3 hours. The extrusion parameters were adjusted as follows: temperature from feed inlet to die head of 80 °C, 90 °C, 90 °C, 90 °C, 90 °C, 95 °C, 95 °C, and 95 °C; screw speed of 45 rpm; pulling speed of 0.7 rpm; winding speed of 1.3 rpm. The mixture was processed through extrusion, film casting, cooling, cutting, and winding to produce a solar cell encapsulant film with a thickness of 0.6 mm.

**Example 7**

6 g of 1,1-bis(tert-butylperoxy)-3,3,5-trimethylcyclohexane, 1.5 g of tert-amyl peroxy carbonate, 3.8 g of trimethylolpropane triacrylate, 2 g of γ-methacryloxypropyl trimethoxysilane, 1 g of γ-(2,3-epoxypropoxy)propyl trimethoxysilane, 0.1 g of antioxidant 1076, and 1 g of antioxidant 1010 were added to 1000 g of the ethylene-α-olefin copolymer obtained in example 2.

The above raw materials were heated to 50 °C and uniformly mixed for 3 hours. The extrusion parameters were adjusted as follows: temperature from feed inlet to die head of 80 °C, 90 °C, 90 °C, 90 °C, 90 °C, 95 °C, 95 °C, and 95 °C; screw speed of 45 rpm; pulling speed of 0.7 rpm; winding speed of 1.3 rpm. The mixture was processed through extrusion, film casting, cooling, cutting, and winding to produce a solar cell encapsulant film with a thickness of 0.6 mm.

**Example 8**

A solar cell encapsulant film was prepared in the same manner as in example 6, except that the ethylene-α-olefin copolymer obtained in example 3 was used to replace the ethylene-α-olefin copolymer obtained in example 1.

**Example 9**

A solar cell encapsulant film was prepared in the same manner as in example 6, except that the ethylene-α-olefin copolymer obtained in example 4 was used to replace the ethylene-α-olefin copolymer obtained in example 1.

**Example 10**

A solar cell encapsulant film was prepared in the same manner as in example 6, except that the ethylene-α-olefin copolymer obtained in example 5 was used to replace the ethylene-α-olefin copolymer obtained in example 1.

**Comparative Example 7**

A solar cell encapsulant film was prepared in the same manner as in example 6, except that the ethylene-α-olefin copolymer obtained in comparative example 1 was used to replace the ethylene-α-olefin copolymer obtained in example 1.

**Comparative Example 8**

A solar cell encapsulant film was prepared in the same manner as in example 6, except that the ethylene-α-olefin copolymer obtained in comparative example 2 was used to replace the ethylene-α-olefin copolymer obtained in example 1.

**Comparative Example 9**

A solar cell encapsulant film was prepared in the same manner as in example 6, except that the ethylene-α-olefin copolymer obtained in comparative example 3 was used to replace the ethylene-α-olefin copolymer obtained in example 1.

**Comparative Example 10**

A solar cell encapsulant film was prepared in the same manner as in example 6, except that the ethylene-α-olefin

copolymer obtained in comparative example 4 was used to replace the ethylene-α-olefin copolymer obtained in example 1.

**Comparative Example 11**

A solar cell encapsulant film was prepared in the same manner as in example 6, except that the ethylene-α-olefin copolymer obtained in comparative example 5 was used to replace the ethylene-α-olefin copolymer obtained in example 1.

**Comparative Example 12**

A solar cell encapsulant film was prepared in the same manner as in example 6, except that the ethylene-α-olefin copolymer obtained in comparative example 6 was used to replace the ethylene-α-olefin copolymer obtained in example 1.

**Example 11**

A solar cell encapsulant film was prepared in the same manner as in example 6, except that the raw materials were heated to 50 °C and uniformly mixed for only 2 hours.

**Example 12**

A solar cell encapsulant film was prepared in the same manner as in example 7, except that the raw materials were heated to 50 °C and uniformly mixed for only 2 hours.

**Example 13**

A solar cell encapsulant film was prepared in the same manner as in example 8, except that the raw materials were heated to 50 °C and uniformly mixed for only 2 hours.

**Example 14**

A solar cell encapsulant film was prepared in the same manner as in example 9, except that the raw materials were heated to 50 °C and uniformly mixed for only 2 hours.

**Example 15**

A solar cell encapsulant film was prepared in the same manner as in example 10, except that the raw materials were heated to 50 °C and uniformly mixed for only 2 hours.

**Comparative Example 13**

A solar cell encapsulant film was prepared in the same manner as in comparative example 7, except that the raw materials were heated to 50 °C and uniformly mixed for only 2 hours.

**Comparative Example 14**

A solar cell encapsulant film was prepared in the same manner as in comparative example 8, except that the raw materials were heated to 50 °C and uniformly mixed for only 2 hours.

**Comparative Example 15**

A solar cell encapsulant film was prepared in the same manner as in comparative example 9, except that the raw materials were heated to 50 °C and uniformly mixed for only 2 hours.

**Comparative Example 16**

A solar cell encapsulant film was prepared in the same manner as in comparative example 10, except that the raw

materials were heated to 50 °C and uniformly mixed for only 2 hours.

**Comparative Example 17**

A solar cell encapsulant film was prepared in the same manner as in comparative example 11, except that the raw materials were heated to 50 °C and uniformly mixed for only 2 hours.

**Comparative Example 18**

A solar cell encapsulant film was prepared in the same manner as in comparative example 12, except that the raw materials were heated to 50 °C and uniformly mixed for only 2 hours.

Table 3: Number of crystal spots in cast films of ethylene-$\alpha$-olefin copolymers

| Examples/Comparative examples | Number of crystal spots |
|---|---|
| Example 6 | 0 |
| Example 7 | 0 |
| Example 8 | 0 |
| Example 9 | 0 |
| Example 10 | 0 |
| Comparative example 7 | 0 |
| Comparative example 8 | 2 |
| Comparative example 9 | 3 |
| Comparative example 10 | 0 |
| Comparative example 11 | 0 |
| Comparative example 12 | 2 |
| Example 11 | 0 |
| Example 12 | 0 |
| Example 13 | 0 |
| Example 14 | 0 |
| Example 15 | 0 |
| Comparative example 13 | 0 |
| Comparative example 14 | 3 |
| Comparative example 15 | 2 |
| Comparative example 16 | 0 |
| Comparative example 17 | 0 |
| Comparative example 18 | 2 |

The number of crystal spots in table 3 was measured in accordance with ASTM D3351.

As shown in Table 3, the number of crystal spots in the cast films of the ethylene-$\alpha$-olefin copolymers described in the present application is significantly lower than that in the cast films of the copolymers of comparative Examples 2, 3, and 6.

The crosslinking degree was evaluated in accordance with the standards of the China Photovoltaic Industry Association (CPIA) and ASTM D2765. The solar cell encapsulant film obtained above was cut into pieces of 10 cm × 10 cm, and then subjected to vacuum lamination at 150 °C for 20 minutes (maintaining vacuum for 5 minutes / applying pressure for 1 minute / releasing pressure for 14 minutes), to obtain crosslinked samples.

The crosslinked samples were cut to appropriate sizes, and 0.5 g was weighed on a 200-mesh wire cage. The sample was dissolved in xylene under reflux for 5 hours. Afterward, the sample was dried in a vacuum oven, and the weight before and after reflux was compared to determine the crosslinking degree of each sample. The crosslinking degree data

for each example and comparative example are presented in table 4.

Table 4: Crosslinking degree data for examples and comparative examples

| Examples/Comparative examples | Crosslinking degree |
|---|---|
| Example 6 | 92.5 |
| Example 7 | 90.8 |
| Example 8 | 92.3 |
| Example 9 | 91.1 |
| Example 10 | 92.3 |
| Comparative example 7 | 88.5 |
| Comparative example 8 | 87.2 |
| Comparative example 9 | 88.1 |
| Comparative example 10 | 86.3 |
| Comparative example 11 | 87.6 |
| Comparative example 12 | 88.1 |
| Example 11 | 89.8 |
| Example 12 | 88.9 |
| Example 13 | 89.4 |
| Example 14 | 88.6 |
| Example 15 | 88.3 |
| Comparative example 13 | 82.5 |
| Comparative example 14 | 82.7 |
| Comparative example 15 | 83.2 |
| Comparative example 16 | 82.4 |
| Comparative example 17 | 82.2 |
| Comparative example 18 | 81.5 |

As shown in table 4, referring to examples 6-10 and comparative examples 7-12, the ethylene-α-olefin copolymer of the present application enhances the crosslinking degree of photovoltaic encapsulant film articles. Furthermore, referring to examples 11-15 and comparative examples 13-18, the ethylene-α-olefin copolymer of the present application maintains a high crosslinking degree, exceeding the requirement of 85% for photovoltaic encapsulant films, even when the mixing time with additives is shortened during film formation. This performance is superior to that of the ethylene-α-olefin copolymers of the comparative examples, thereby enabling shortened mixing time and improved processing efficiency. Since the ethylene-α-olefin copolymer of the present application facilitates the migration of additives from the particle surface into the interior of the particles, a higher crosslinking degree can be achieved within the same mixing time, or alternatively, the crosslinking requirement can still be met even with shorter mixing time.

Referring to the examples and the comparative examples in tables 1-2, it can be seen that the ethylene-α-olefin copolymer according to the present application not only exhibits high mechanical properties but also addresses the issues of prolonged additive mixing time or insufficient crosslinking degree during processing, while demonstrating favorable cast-film formability and effectively reducing the formation of crystal spots.

Specific embodiments of the present application are described above. However, the present application is not limited to the above embodiments. Any modifications, equivalent substitutions, or improvements made within the spirit and principles of the present application shall be encompassed within the protection scope of the present application.

## Claims

**1.** An ethylene-α-olefin copolymer having the following properties:

(a) a density of 0.860 $g/cm^3$ to 0.905 $g/cm^3$;
(b) a weight-average molecular weight in a range of 20000 g/mol to 150000 g/mol, and a polydispersity index PDI in a range of 2.2 to 3, as measured by GPC-IR;
(c) a unimodal elution peak as determined by TGIC, wherein a product of peak width at half height and half of peak height is in a range of 38 to 48, and a temperature at an intersection point between a half-height line and a right side of an elution curve is in a range of 88°C to 98°C; and
(d) a content of a soluble substance in the elution peak, as determined by TGIC, of less than or equal to 3.0%.

**2.** The ethylene-α-olefin copolymer according to claim 1, wherein

the ethylene-α-olefin copolymer has a comonomer incorporation rate of 20 wt% to 40 wt%; and/or
the ethylene-α-olefin copolymer has a melt flow rate $MFR_2$ of 1 g/10min to 30 g/10min, as measured at 190°C under a load of 2.16 kg; and/or
the ethylene-α-olefin copolymer has a melting peak temperature Tm of 30°C to 90°C; and/or
the α-olefin in the ethylene-α-olefin copolymer is a $C_3$-$C_{20}$ olefin or a mixture thereof.

**3.** The ethylene-α-olefin copolymer according to claim 1 or 2, wherein
in the ethylene-α-olefin copolymer, the α-olefin is one or more selected from the group consisting of propylene, 1-butene, 1-pentene, 4-methyl-1-pentene, 1-hexene, 1-heptene, 1-octene, 1-decene, 1-undecene, 1-dodecene, 1-tetradecene, 1-hexadecene, and 1-eicosene.

**4.** A method for preparing the ethylene-α-olefin copolymer according to any one of claims 1 to 3, comprising the steps of:

carrying out continuous solution polymerization of ethylene with one or more α-olefins in a reactor in the presence of a catalyst and optionally a chain transfer agent; and
quenching at the reactor outlet with a water-alcohol mixture to obtain the ethylene-α-olefin copolymer;
wherein polymerization reaction conditions satisfy the following formula:

$$0.70 < \frac{F_{ethylene} / F_{catalyst}}{C_{catalyst\ efficiency}} < 0.94$$

wherein $F_{ethylene}$ is a feed rate of the ethylene, with a unit of kg/h;
$F_{catalyst}$ is a feed rate of the catalyst, with a unit of g/h; and
$C_{catalyst\ efficiency}$ is a mass of the polymer produced per unit mass of the catalyst per hour, with a unit of kg/g.

**5.** The method for preparing the ethylene-α-olefin copolymer according to claim 4, wherein

the water-alcohol mixture is a mixture of water and a $C_2$-$C_{10}$ alcohol, with a weight ratio of the water to the $C_2$-$C_{10}$ alcohol of 0.1 to 10; and/or
the $C_2$-$C_{10}$ alcohol is one or more selected from the group consisting of ethanol, propanol, butanol, 2-methylpropanol, pentanol, 2-methylbutanol, 3-methylbutanol, 2-ethylpropanol, hexanol, 2-methylpentanol, 3-methylpentanol, 4-methylbutanol, 3-ethylbutanol, heptanol, 2-methylhexanol, 3-methylhexanol, 4-methylhexanol, 5-methylhexanol, 3-ethylpentanol, 4-ethylpentanol, octanol, isooctanol, nonanol, isononanol, and decanol; and/or
the catalyst is a homogeneous catalyst; and/or
a solvent used in the solution polymerization is a hydrocarbon solvent; and/or
a co-catalyst is used in the solution polymerization; and/or
the solution polymerization is carried out at a temperature of 120°C to 200°C and a pressure of 2 MPa to 10 MPa.

**6.** The method for preparing the ethylene-α-olefin copolymer according to claim 5, wherein

the catalyst is a metallocene catalyst or a post-metallocene catalyst; and/or
the co-catalyst is a composition comprising one or more selected from the group consisting of aluminoxanes, alkylaluminum compounds, and alkylaluminum chlorides, or a composition comprising one or more selected from the group consisting of aluminoxanes, alkylaluminum compounds, and alkylaluminum chlorides in combination with one or more organoboron compounds; and/or
the solution polymerization is carried out at a temperature of 130°C to 190°C and a pressure of 2 MPa to 9 MPa.

**7.** An encapsulant composition, wherein
the encapsulant composition comprises the ethylene-α-olefin copolymer according to any one of claims 1 to 3, or the ethylene-α-olefin copolymer prepared by the method according to any one of claims 4 to 6; and optionally the following components:
one or more components selected from the group consisting of a crosslinking agent, a co-crosslinking agent, a coupling agent, and an antioxidant.

**8.** The encapsulant composition according to claim 7, wherein

the crosslinking agent is a peroxide-based crosslinking agent; and/or
the co-crosslinking agent is one or more multifunctional acrylates; and/or
the coupling agent is a silane-type coupling agent; and/or
the antioxidant is one or more selected from the group consisting of hindered phenolic antioxidants, phosphate ester antioxidants and a combination thereof.

**9.** The encapsulant composition according to claim 7 or 8, wherein

based on 100 parts by weight of the ethylene-α-olefin copolymer,
the crosslinking agent is used in an amount of 0.1 to 5 parts by weight; and/or
the co-crosslinking agent is used in an amount of 0.1 to 5 parts by weight; and/or
the coupling agent is used in an amount of 0.1 to 3 parts by weight; and/or
the antioxidant is used in an amount of 0.01 to 1 part by weight.

**10.** An encapsulation film, wherein
the encapsulation film is prepared from the encapsulant composition according to any one of claims 7 to 9.

**11.** The encapsulation film according to claim 10, wherein
the encapsulation film is a solar cell encapsulation film.

## INTERNATIONAL SEARCH REPORT

International application No.
**PCT/CN2024/096374**

**A. CLASSIFICATION OF SUBJECT MATTER**

C08F210/16(2006.01)i; C08F210/14(2006.01)i; C08F210/08(2006.01)i; C08F4/64(2006.01)i; C08F4/6592(2006.01)i; C09J123/08(2006.01)i; C09J4/06(2006.01)i; H01L31/048(2014.01)i

According to International Patent Classification (IPC) or to both national classification and IPC

**B. FIELDS SEARCHED**

Minimum documentation searched (classification system followed by classification symbols)

IPC:C08F C09J H01L

Documentation searched other than minimum documentation to the extent that such documents are included in the fields searched

Electronic data base consulted during the international search (name of data base and, where practicable, search terms used)

CNTXT; ENTXT; DWPI; CNKI; WEB OF SCIENCE: 乙烯, α-烯烃, 密度, 分子量, PDI, TGIC, 洗脱, 茂金属, 茂后金属, 包封剂, 太阳能电池, 封装, 胶膜, 交联, 晶点, ethylene, α-olefins, density, molecular weight, PDI, TGIC, elution, metallocene, postmetallocene, encapsulant, solar cell, encapsulation, glue film, cross-linking, crystal point

**C. DOCUMENTS CONSIDERED TO BE RELEVANT**

| Category* | Citation of document, with indication, where appropriate, of the relevant passages | Relevant to claim No. |
|---|---|---|
| X | CN 117467057 A (WANHUA CHEMICAL GROUP CO., LTD.) 30 January 2024 (2024-01-30) description, paragraphs 0072-0174 | 1-11 |
| X | CN 117343226 A (WANHUA CHEMICAL GROUP CO., LTD.) 05 January 2024 (2024-01-05) description, paragraphs 0046-0066 | 1-11 |
| A | CN 117327220 A (WANHUA CHEMICAL GROUP CO., LTD.) 02 January 2024 (2024-01-02) entire document | 1-11 |
| A | CN 116789883 A (WANHUA CHEMICAL GROUP CO., LTD.) 22 September 2023 (2023-09-22) entire document | 1-11 |
| A | CN 114867759 A (DOW GLOBAL TECHNOLOGIES INC.) 05 August 2022 (2022-08-05) entire document | 1-11 |

☑ Further documents are listed in the continuation of Box C. ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **02 January 2025** | **02 January 2025** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | Telephone No. |

Form PCT/ISA/210 (second sheet) (July 2022)

**INTERNATIONAL SEARCH REPORT**

International application No.
**PCT/CN2024/096374**

**C. DOCUMENTS CONSIDERED TO BE RELEVANT**

| Category* | Citation of document, with indication, where appropriate, of the relevant passages | Relevant to claim No. |
|---|---|---|
| A | JP 2006143901 A (TOSOH CORP.) 08 June 2006 (2006-06-08)<br>entire document | 1-11 |
| A | WO 2024073260 A1 (EXXONMOBIL CHEMICAL PATENTS INC.) 04 April 2024 (2024-04-04)<br>entire document | 1-11 |

Form PCT/ISA/210 (second sheet) (July 2022)

**INTERNATIONAL SEARCH REPORT**
**Information on patent family members**

International application No.
**PCT/CN2024/096374**

| Patent document cited in search report | Publication date (day/month/year) | Patent family member(s) | Publication date (day/month/year) |
|---|---|---|---|
| CN 117467057 A | 30 January 2024 | None | |
| CN 117343226 A | 05 January 2024 | CN 117343226 B | 09 April 2024 |
| CN 117327220 A | 02 January 2024 | None | |
| CN 116789883 A | 22 September 2023 | CN 116789883 B | 09 January 2024 |
| CN 114867759 A | 05 August 2022 | US 2022389139 A1 | 08 December 2022 |
| | | WO 2021128126 A1 | 01 July 2021 |
| | | WO 2021133640 A1 | 01 July 2021 |
| | | EP 4081560 A1 | 02 November 2022 |
| | | JP 2023509109 A | 07 March 2023 |
| | | BR 112022012719 A2 | 06 September 2022 |
| | | KR 20220123248 A | 06 September 2022 |
| JP 2006143901 A | 08 June 2006 | None | |
| WO 2024073260 A1 | 04 April 2024 | None | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CN 114315883 A
- CN 202010793023
- CN 114867759 A